# EUROPEAN PATENT SPECIFICATION

(11) **EP 2 440 406 B1**
(45) Date of publication and mention of the grant of the patent: **25.11.2020**
(21) Application number: 10786735.0
(22) Date of filing: 09.06.2010
(51) Int. Cl.: B32B 27/00

(54) **WEATHERABLE POLYVINYLIDENE FLUORIDE COATED SUBSTRATES**
WETTERFESTE POLYVINYLIDEN-FLUORID-BESCHICHTETE SUBSTRATE
SUBSTRATS REVÊTUS DE FLUORURE DE POLYVINYLIDÈNE RÉSISTANT AUX INTEMPÉRIES

(30) Priority: 10.06.2009 US 185782 P
(43) Date of publication of application: 18.04.2012
(73) Proprietor: Arkema Inc., King Of Prussia, PA 19406 (US)
(72) Inventor: KOSAR, Walter, Pottstown PA 19465 (US); WOOD, Kurt A., Abington PA 19001 (US); SKILTON, Wayne, Jenkintown PA 19046 (US); O'BRIEN, Gregory S., Downingtown PA 19335 (US); AUBART, Mark A., West Chester PA 19380 (US)
(74) Representative: Arkema Patent
(86) International application number: PCT/US2010/037888
(87) International publication number: WO 2010/144520

(56) References cited:
- WO-A1-2008/157159
- WO-A1-2008/157159
- WO-A2-2008/019229
- FR-A1- 2 896 445
- JP-A- 2007 035 694
- US-A- 5 718 772
- US-A1- 2008 261 037
- US-A1- 2009 133 340
- US-B2- 6 777 610

## Description

### Field of the Invention

The invention relates to architectural substrates coated with a polyvinylidene fluoride (PVDF) dispersion coating to produce a weatherable material. One specific use is as a PVDF coating on a frontsheet or backsheet of a photovoltaic module for capturing and using solar radiation. The polyvinylidene fluoride coating is exposed to the environment and provides chemical resistance, low water vapor transmission, electrical insulation, and weathering protection especially from UV light.

### Background of the Invention

Photovoltaic modules consist of an outer (front) glazing material, solar cells generally encapsulated in a clear packaging (encpsulant) for protection, and a backsheet. The solar cells are made of materials known for use in solar collectors, including, but not limited to, silicon, cadmium indium selenide (CIS), cadmium indium gallium selenide (CIGS), and quantum dots. The back sheet is exposed to the environment on the backside of the photovoltaic module. The primary function of the back sheet is to provide the low water vapor transmission, dielectric isolation for the electrical circuit, UV and oxygen barrier properties, and is necessary to protect the silicon wafers (photocells) from degradation induced by reaction with water, oxygen or UV radiation.

The backsheet of the collector can be a metal, such as steel or aluminum. However, more recently polymeric materials have been used in the back sheet. These include a polyvinyl fluoride (PVF) material from DuPont (US 6,646,196); an ionomer/nylon alloy (6,660,930), and polyethylene terephthalate (PET) have all been used as the backsheet layer in photovoltaic modules, alone and in combination. PET is a polymer with excellent water vapor resistance and relatively lower cost, however it is susceptible to degradation from exposure to environmental influences, such as UV radiation, IR radiation, and ozone. In many backsheet constructions, PET is protected by the use of PVF films, which are tough, relativelyphoto-stable, chemically resistant and unaffected by long-term moisture exposure. However, PVF films are relatively expensive. Typical constructions of photovoltaic back sheets are PVF/PET/PVF, PVF/PET/AI/PVF and PE/PET/PVF multi-layered laminated films. However, these constructions can suffer from the drawback of poor adhesion of the PVF to PET or other substrates. Adhesion is typically augmented by treatment of the polymeric surfaces with an adhesive, and/or with a high energy surface treatment such as corona discharge or similar technology to increase adhesion in the PVF film.

Another issue is that the thickness of the PVF film is typically ∼ 25 um. Since the PVF resin is much more expensive than PET resin, the overall cost of the backsheet is strongly related to the thickness of the fluoropolymer layer. Reducing the overall cost of the photovoltaic module is very important to commercial success of this technology.

One alternative is the use of polyvinylidene fluoride (PVDF) as the fluoropolymer in backsheet compositions, as described in WO 08/157,159. PVDF can provide performance, processing, and cost improvements over current technology. Backsheets formed from polyvinylidene fluoride (PVDF), polyvinylidene fluoride copolymers and polyvinylidene fluoride blends can take advantage of the properties of polyvinylidene fluoride to overcome the issues with other materials. The PVDF can be in the form of a solvent or aqueous-based coating.

Solvent-based fluoropolymer coatings useful in photovoltaic applications are described in US 20070154704, US 20070166469 and US 2008/0261037. These applications describe a blend of a fluoropolymer (PVF or PVDF) with a small amount of an adhesive polymer having functional groups or cross-linkable groups. The solvents used in these applications to form the coatings are either water-miscible or very water soluble (hydrophilic), such as n-methyl pyrrolidone, acetone, propylene carbonate, methylethyl ketone, etc. These solvents can lead to coating failure by water uptake if they are not completely removed in the bake cycle.

Applicant has now developed useful polyvinylidene fluoride dispersion coatings for application to architectural substrates, including a PV backsheet or frontsheet substrate, that solve many of the problems with current laminated and coated structures. A simple PVDF coating containing hydrophobic solvents, nonreactive compatible co-resins (preferably acrylic co-resins) can be used to coat and protect a photovoltaic backsheet or other architectural substrate, without the need for cross-linking additives. A further benefit of the present PVDF dispersion coating composition is the ability to dry the film at only modestly elevated temperatures (170-180°C) which prevents shrinkage and embrittlement of the PET film substrate.

Additionally, the PVDF can be functionalized to provide an adhesion advantage. This functionalized PVDF could be used without any acrylic co-resin, or used in small amounts with a much larger amount of acrylic co-resin. Further, an aqueous PVDF/acrylic interpenetrating network dispersion coating, as well as PVDF/acrylic hybrid compositions could also be used to provide fluoropolymer coatings for a photovoltaic backsheet or other substrates.

### Summary of the invention

The invention relates to a photovoltaic module, having:
a. an outer transparent glazing material;
b. encapsulated interconnected solar cells; and
c. a backsheet having a substrate coated on the side exposed to the environment, or both sides, with a dispersion fluoropolymer composition comprising a mixture of a polyvinylidene fluoride (PVDF) and a non-functionalized acrylic.

The invention further relates to a photovoltaic module, having:
a) an outer transparent glazing material;
b) encapsulated interconnected solar cells; and
c) a backsheet having a substrate coated on the side exposed to the environment, or both sides, with a dispersion functionalized fluoropolymer composition.

### Detailed description of the Invention

The invention relates to architectural structures, and in particular a photovoltaic backsheet, having a fluoropolymer coating, preferably a PVDF coating applied to one or both sides of a substrate materials, the coating formulation is a solvent-based or aqueous-based dispersion coating. The PVDF can be functionalized for increased adhesion. The PVDF resin may be combined with other compatible co-resins to further reduce cost and provide better film formation.

By "photovoltaic modules", as used herein is meant a construction of photovoltaic cell circuits sealed in an environmentally protective laminate. Photovoltaic modules may be combined to form photovoltaic panels that are pre-wired, field-installable units. A photovoltaic array is the complete power-generating unit, consisting of any number of PV modules and panels.

By "hydrophobic" latent solvent as used herein is meant a solvent which has a solubility in water of less than 10% by weight at 25°C.

The backsheet of the invention will contain one or more fluoropolymer or copolymer layers, with a fluoropolymer composition being the outermost sheet exposed to the environment.

The term fluoropolymer denotes any polymer that has in its chain at least one monomer chosen from compounds containing a vinyl group capable of opening in order to be polymerized and that contains, directly attached to this vinyl group, at least one fluorine atom, at least one fluoroalkyl group or at least one fluoroalkoxy group. Examples of fluoromonomers include, but are not limited to vinyl fluoride; vinylidene fluoride (VDF); trifluoroethylene (VF3); chlorotrifluoroethylene (CTFE); 1,2-difluoroethylene; tetrafluoroethylene (TFE); hexafluoropropylene (HFP); perfluoro(alkyl vinyl) ethers, such as perfluoro(methyl vinyl) ether (PMVE), perfluoro(ethyl vinyl) ether (PEVE) and perfluoro(propyl vinyl) ether (PPVE); perfluoro(1,3-dioxole); perfluoro(2,2-dimethyl-1,3-dioxole) (PDD). Preferred flouropolymers are the homopolymers and copolymers of vinyl fluoride and/or vinylidene fluoride.

The most preferred fluoropolymers are those that respond to latent solvents (a latent solvent being one that does not dissolve or substantially swell the fluoropolymer resin at room temperature, but will solvate the fluorpolymer resin at elevated temperatures. PVDF is the fluoropolymer used according to the invention.

In the following description, PVDF will be used as fluoropolymer.

Each PVDF layer composition of the invention may be a homopolymer, a copolymer, a terpolymer or a blend of a PVDF homopolymer or copolymer with one or more other polymers that are compatible with the PVDF (co)polymer. PVDF copolymers and terpolymers of the invention are those in which vinylidene fluoride units comprise greater than 40 percent of the total weight of all the monomer units in the polymer, and more preferably, comprise greater than 70 percent of the total weight of the units. Copolymers, terpolymers and higher polymers of vinylidene fluoride may be made by reacting vinylidene fluoride with one or more monomers from the group consisting of vinyl fluoride, trifluoroethene, tetrafluoroethene, one or more of partly or fully fluorinated alpha-olefins such as 3,3,3-trifluoro-1-propene, 1,2,3,3,3-pentafluoropropene, 3,3,3,4,4-pentafluoro-1-butene, and hexafluoropropene, the partly fluorinated olefin hexafluoroisobutylene, perfluorinated vinyl ethers, such as perfluoromethyl vinyl ether, perfluoroethyl vinyl ether, perfluoro-n-propyl vinyl ether, and perfluoro-2-propoxypropyl vinyl ether, fluorinated dioxoles, such as perfluoro(1,3-dioxole) and perfluoro(2,2-dimethyl-1,3-dioxole), allylic, partly fluorinated allylic, or fluorinated allylic monomers, such as 2-hydroxyethyl allyl ether or 3-allyloxypropanediol, and ethene or propene. Preferred copolymers or terpolymers are formed with vinyl fluoride, trifluoroethene, tetrafluoroethene (TFE), and hexafluoropropene (HFP).

Especially preferred copolymers are of VDF comprising from about 71 to about 99 weight percent VDF, and correspondingly from about 1 to 29 percent HFP percent VDF, and correspondingly from about 1 to about 29 percent TFE; from (such as disclosed in U.S. Pat. No. 3,178,399); and from about 71 to 99 weight percent VDF, and correspondingly from about 1 to 29 weight percent trifluoroethylene.

Especially preferred thermoplastic terpolymers are the terpolymer of VDF, HFP and TFE, and the terpolymer of VDF, trifluoroethene, and TFE. The especially preferred terpolymers have at least 71 weight percent VDF, and the other comonomers may be present in varying portions, but together they comprise up to 29 weight percent of the terpolymer.

In one embodiment, especially when the fluoropolymer is to be exposed to high temperature processing, it is useful if the melting point of the fluoropolymer is greater than 125°C, more preferably greater than 140°C, and most preferably greater than 150°C.

The PVDF could also be grafted with a reactive monomer such as maleic anhydride, which can bond to surfaces and improve adhesion. These functionalized resins are described in US 7,241,817. Such resins have been for improved PVDF laminate and coating adhesion.

The PVDF layer could also be a blend of a PVDF polymer with a compatible polymer, such as, but not limited to, an acrylic polymer or copolymer, like polymethyl methacrylate (PMMA) or copolymers of MMA with acrylic monomers such as ethylacrylate or butylacrylate, where the PVDF makes up greater than 40 weight percent. PVDF and PMMA can be melt blended to form a homogeneous blend. A preferred embodiment is a blend of 50 - 90 weight percent of PVDF and 10 - 50 weight percent of polymethyl methacrylate or a polymethylmethacrylate copolymer, with a ratio of 50-70 PVDF and 10-30 PMMA homo- or co-polymer being preferred. Preferably the acrylic polymer is non-functionalized, which means it does not contain reactive functional groups such as carboxylate, amine, anhydride, isocyanate, or epoxy. The PVDF or some part of it can be functionalized. The co-resin or the PVDF can be cross-linked to enhance properties. Particularly for lower melting point copolymers (< 150°C) the thermal resistance of these coatings to future PV module lamination conditions (150° C for 5 minutes) can be improved by use of a cross-linkable formulation. In one embodiment, a functional PVDF and a non-functional acrylic polymer could be blended to form the PVDF composition, at a ratio of from 10:90 to 90:10.

In a further embodiment of the invention, fluoropolymer compositions may be used which are aqueous dispersions of the polymers, and which contain little or no organic solvent (less than about 20 weight percent on total formulation weight, preferably less than about 10 weight percent). One example of such aqueous compositions is fluoropolymer/acrylic hybrid dispersions, also known as acrylic-modified fluoropolymer ("AMF") dispersions. General methods to manufacture AMF dispersions are described in US 5,646,201, US 6,680,357, and provisional patent application US 61/078619. AMF dispersions are formed by swelling a fluoropolymer seed dispersion withone or more acrylic monomers and then polymerizing the acrylic monomers. The AMF dispersions can be of one or more different types, including in the form of an interpenetrating network dispersion in water (for one type of acrylic monomer or acrylic monomers miscible with the fluoropolymer seed, or in the form of a hybrid structure where two or more different acrylic monomers are used - in which one of more are immiscible with the fluorpolymer seed - resulting in a partial interpenetrating network, with associated polymer phases.

In one preferred AMF embodiment of the invention, a high melting point fluoropolymer seed is used (m.p. >125°C and preferably >140°C and most preferably > 150°C), along with a non-functional acrylic polymer which is miscible with the fluoropolymer component. Examples of such miscible acrylic polymer compositions are given in the patents and applications cited herein. In this embodiment, the morphology of the AMF dispersion particles may be either of the "core-shell" or "IPN" type. In practice, IPN type dispersions based on PVDF homopolymers or copolymers may be defined as those which have a first heat DSC enthalpy of melting of less than about 20 Joules/gram on dry polymer. If dispersions of the core-shell type are used in the invention, it is necessary to heat the coating at some point in the fabrication process (when drying the coating, or subsequently during a lamination or heat treatment step) to a temperature which is at least within 10 C of the crystalline melting point of the fluoropolymer component (or higher), in order to achieve an intimate mixture of the fluoropolymer and acrylic components. If dispersions of the IPN type are used, it is not necessary to heat the composition at any point above the minimum film formation temperature of the dispersion, i.e. that minimum temperature which is required to form the aqueous composition into a continuous dry film.

A second preferred AMF embodiment is an AMF formed from a PVDF copolymer seed having little or no crystallinity (defined as a crystalline melting point of < 125°C and a total crystallinity as measured by differential scanning calorimetry of less than 20 J/g), along with a thermodynamically miscible acrylic component. In this case the material would be likely to have an IPN type morphology, and it is not necessary to heat the composition at any point above the minimum film formation temperature of the dispersion, i.e. that minimum temperature which is required to form the aqueous composition into a continuous dry film. In this second preferred AMF embodiment, the IPN may be internally cross-linked by means of using a reactive monomer incorporated in the IPN or, an added reactive co-resin that can be internally cross-linked may be used, to enhance the thermal resistance. The reactive components in such cases are not designed to react with the substrate. Generally the ratio of fluoropolymer seed to the acrylic monomers is in the range of 10-90 parts by weight of fluoropolymer to 90-10 parts by weight of the acrylic, preferably 50-80 parts by weight of fluoropolymer to 50-20 parts by weight of the acrylic. A further embodiment is a fluoropolymer/acrylic hybrid in which two or more different vinyl monomer compositions are sequentially polymerized in the presence of the fluoropolymer seed, as described in provisional patent application US 61/078619.

The fluoropolymer composition, in addition to PVDF may contain other additives, such as, but not limited to impact modifiers, UV stabilizers, plasticizers, process aids, fillers, coloring agents, pigments, antioxidants, antistatic agents, surfactants, toner, pigments, and dispersing aids. Since UV resistance is a prime function of the back layer, UV absorbers are present at 0-10 wt. percent, and preferably present at levels of from 0.5 percent to 7.0 weight percent in, and based on, the PVDF and/or barrier layers. In a preferred embodiment, a pigment is added to a fluoropolymer composition for coating the backsheet of a photovoltaic module to aid in reflectance of light back into the solar module, absorbing or blocking UV light transmittance. Pigments can be employed at levels from 0.5 weight percent to 50 percent by weight, based on the polymer. In the case of a photovoltaic front sheet, a clear coating is desired, containing from 0 to 1 weight percent of pigment. In one embodiment, a weatherable fluorpolymer composition is made up of 30 to 100 weight percent fluoropolymer; 0 to 70 weight percent of a compatible resin, for example a (meth)acrylic polymer or copolymer; 0 - 30 weight percent of a mineral filler or pigment; and 0 to 7 weight percent of other additives.

The fluoropolymer composition may contain 2 to 33% of a low molecular weight cross-linker that cross-links the fluoropolymer formulation to improve heat resistance. Examples of useful cross-linkers include DESMODUR N3300, DESMODUR 4265 BL and CYMEL 300 and 303. The addition of the cross-linking improves thermal stability resistance of the coating, hardness and scratch resistance and even solvent resistance. In one preferred embodiment, the fluoropolymer composition contains no cross-linking agents.

The PVDF composition is coated onto a polymer support substrate in the photovoltaic backsheet or frontsheet. The support layer is used to support the PVDF coating, and may serve other functions, such as a moisture barrier, and/or dielectric layer. The polymer support layer may be a single layer, or may have a multi-layer construction with two or more materials. Examples of useful support layers of the invention include, but are not limited to aluminum foil, polyethylene terephthalate (PET), polyethylene napthalate (PEN), functionalized polyolefins and alloys thereof and ethylene vinylalcohol. One preferred support layer is a PET layer substrate. The support layer substrate of the invention is in the form of a sheet or film, and has a thickness of from 25 to 500 um, preferably 50 to 250 microns. The substrate is typically formed by known means, such as biaxially stretching and heat setting processes.

While it is possible to practice the invention with a non-treated support layer and still have good adhesion, support layers such as polyethylene terephthalate are generally pre-treated by means known in the art to improve adhesion, such as coating with a polymeric primer, or treating with corona, and/or plasma. In one perfered embodiment, the substrate is primed with a primer that is compatible with the fluoropolymer, the co-resin, or both. The co-resin in Applicant's primers used on the fluoropolymer composition are not designed to react with the primers on the PET. The primers only improve surface wetting, adsorption, and interlayer diffusion of the fluoropolymer composition. The most preferred primer compositions are acrylic based, which results in good compatibility with the PVDF coating

PET exhibits excellent water vapor resistance at a relatively low cost; however, it is susceptible to degradation from exposure to environmental influences, such as UV and IR radiation, and ozone. In the embodiments presented below, PET is used as an exemplary support layer, though one of ordinary skill in the art can easily imagine other polymeric support layers substituted for the PET.

The PVDF containing backsheet generally has a total thickness of from 25 microns to 500 microns, preferably from 75 to 350 microns in thickness, and can be a single layer, or a multi-layer construction. In one embodiment, the backsheet consists of a 10 mil (250 um) barrier layer with a 5 to 25 micron, preferably a 10 to 20 micron PVDF layer on one or both sides.

The support layer may have a polyvinylidene fluoride layer on one or both sides. When the PVDF layer is on both sides of a barrier layer, each side is preferably the same composition, to aid in manufacturing, though the layers could also have different thicknesses and compositions.

The preferred approach to forming a polyvinylidene fluoride outer layer is by coating with a solvent or aqueous-based dispersion coating composition. A fluoropolymer coating may be applied by known means onto a surface treated PET layer, such as, but not limited to brushing, spraying, dipping, laser-jet, etc. The curing temperatures for solvent dispersion coatings can range from 150 - 230°C. The most preferred curing temperature of the PVDF solvent coating formulations should be between 150 - 180°C. Higher curing temperatures (> 180°C) should be avoided to prevent shrinkage and embrittlement of the PET film. Example 17 lists several formulations for curing in this preferred temperature range. Because of the need for lower baking temperatures, proper solvent selection (e.g. boiling point) is crucial for successful formulating. Solvents with higher boiling points may not completely evaporate at lower bake temperatures, and the residual solvent could lead to coating failure.

In general, to form the fluoropolymer coating composition of the invention, dry PVDF is blended with a hydrophobic solvent or mixture of such solvents, a suitable dry pigment (which may also be pre-dispersed in a non-water soluble solvent), and an acrylic copolymer resin (which may be pre-dissolved in a non-water soluble solvent or added in a dry state). This mixture is then blended by either use of a high shear agitator (such as a Cowles dispersing element) or by use of milling balls, paint shaker agitation, or other means known in the art. These, and similar, methods of dispersion are well know to those skilled in the art of paint formulation.

This fluoropolymer dispersion composition is cast onto a suitable carrier / substrate sheet using either roll coating, spray coating, or doctor blade application. Application thickness will depend upon formulation viscosity, but will be adjusted to give dry coating thicknesses of 10 - 50 um, preferably 15-25 um. The coating is typically baked at 170 - 200°C for 1 - 5 minutes to cure the coating. In the most preferred embodiment, the coating is baked at 170 - 180°C for 1 - 2 minutes.

The most preferred fluoropolymer compositions are non -aqueous dispersions, rather than solutions. The solvents used to make such dispersions should primarily be hydrophobic, latent solvents for the fluoropolymer, i.e. solvents which are good solvents for the fluoropolymer at elevated temperatures, but not at ambient temperature. When an active solvent is used (one that substantially dissolves PVDF at room temperature) it is used as a co-solvent at 30 percent or less by weight of the total amount of solvent.

The use of hydrophobic solvents (< 10% solubility in water at 25°C) is preferred due to potential adhesion failure when water miscible solvents are used. If water miscible solvents such as NMP are used, and traces of the solvent remain in the coating, then the coating may be prone to water absorption. Such absorption of water will lead to blistering and delamination of the coating, which will then lead to failure of the backsheet construction. The table below lists several solvents commonly used in coating formulations along with their water solubility.

**TABLE 1**

| Solvent | Solubility in water @ 25°C (wt%) | Boiling Point (°C) |
|---|---|---|
| Isophorone | 1.46 | 215 |
| Cyclohexanone | 2.3 | 157 |
| Methyl-isobutyl-ketone | 1.9 | 118 |
| (MIBK) | | |
| Diisobutyl-ketone (DIBK) | 0.06 | 168 |
| Tert-butylacetate | 2.05 | 98 |
| Propylene carbonate | 17.5 | 242 |
| Methyl-ethyl-ketone (MEK) | 26 | 80 |
| Acetone | 100 | 56 |
| N-Methylpyrrolidone (NMP) | 100 | 202 |
| Dimethylsulfoxide (DMSO) | 100 | 189 |
| N,N-Dimethylacetamide | 100 | 166 |
| (DMAC) | | |
| γ-Butyrolactone | 100 | 204 |

In another embodiment of this invention, the pure PVDF resin is blended with a maleic anhydride grafted PVDF resin (MA-PVDF) to improve overall adhesion of the coating. The combination of PVDF + MA-PVDF is mixed with the other ingredients and solvents as described above, and the coating applied and cured.

In yet another embodiment, the MA-PVDF resin may be predissolved in an active solvent such as NMP prior to mixing with the rest of the PVDF formulation. While the water-miscible NMP solvent may lead to adhesion problems in pure PVDF coatings, the enhanced adhesion of MA-PVDF resin will compensate for the presence of this co-solvent. In such a blend, the overall amount of NMP will be less than 30% of the total solvent composition.

In a further embodiment, a solution is formed of pure MA-PVDF resin in an active solvent such as NMP, along with acrylic copolymer resin and pigment additives, to make a coating formulation. The enhanced adhesion of the MA-PVDF resin will compensate for the use of water-miscible solvent.

In addition to the fluoropolymer compositions of the invention being useful as coatings for both the front sheet and back sheet of a photovoltaic module, the coating compositions can also find use as a weatherable coating in other architectural applications, such as in architectural glazing, roofing and siding.

Unless otherwise noted in the text, percents are given as weight percent, and molecular weights are weight average molecular weight.

### EXAMPLES

### Example 1 - Organic solvent dispersion coating

A dispersion coating was formulated with PVDF homopolymer resin (an emulsion polymer with Mw 450K, Mn 130K, based on PMMA calibration), and an acrylic copolymer (PARALOID B44 from Rohm and Haas). The formulation of Table 2 was mixed for 30 minutes with 125g of 4 mm glass beads in a paint shaker. The coating was applied to a primed PET film. The coating was allowed to flash at room temperature for 10 minutes followed by baking at 200°C (392°F) for ten minutes. A smooth white coating resulted. This coating was tested by both immersion in 100°F water for 1 week, and 85°F/85% RH for 1000 hours followed by cross hatch adhesion test (ASTM D3359 Measuring Adhesion by Tape Test). This coating successfully passed the adhesion test (see Table 17). In the D3359 test, perpendicular cross cuts are made with a special cutting tool the creates 100 small squares. Tape is applied and peeled back to try and remove the squares. In our testing, we counted the number of squares removed by the tape. If more than 20 squares (20%) pulled off, we failed the coating. If less than 20% squares peeled off, we considered the coating to pass the adhesion test. This test was used for testing on all subsequent examples after the coatings were exposed to 1000 hours of 85% relative humidity @ 85°C (damp heat exposure).

**TABLE 2**

| **Solvent Dispersion Example #1** | **Amount (g)** |
|---|---|
| PVDF homopolymer resin | 20.5 |
| Acrylic copolymer | 8.8 |
| Toluene | 14.0 |
| Isophorone | 41.8 |
| R-960 - TiO2 | 15.8 |

### Example 2 Aqueous dispersion coating

An AMF dispersion was prepared according to the method of the Table I Comparative Examples in US 6680357, incorporated herein by reference, with a nonreactive acrylic composition of 66% methyl methacrylate, 31% ethyl acrylate, 3% methacrylic acid and a PVDF homopolymer: acrylic ratio of 70:30. The dispersion was neutralized with aqueous ammonia to a pH of about 8.0 and had a solids content of 37.7 wt%. The dispersion had a first heat DSC enthalpy of melting of 32 Joules/gram on dry polymer, with a broad crystalline melting peak in the 160-170°C range.

A white aqueous coating was formulated based upon this dispersion, using the following formulation:

**TABLE 3**

| **Aqueous Latex Example 2** | **Amount, g** |
|---|---|
| | |
| AMF dispersion | 100.0 |
| Diethylene glycol butyl ether | 7.56 |
| Pigment concentrate, from below: | 28.3 |

**TABLE 4**

| **Pigment concentrate** | **Amount, g** |
|---|---|
| Water | 149.3 |
| DISPER BYK 190 (dispersing agent)- Altana | 13.8 |
| Ammonia | 0.3 |
| TEGOFOAMEX 810 (Evonik) | 1.3 |
| TRITON CF-10 (Dow Chemical) | 5.5 |
| TIPURE R-960 rutile TiO2 (DuPont) | 552.1 |

The pigment concentrate was prepared using a Cowles high speed mixer where it was run at 2000 rpm for 15 minutes and then 4000 rpm for 30 minutes. The latex formulation was mixed using a low speed mixing stirrer at 500 rpm for 10 minutes.

The white aqueous coating was applied to the same pre-treated PET as in example 1 using a 5 mil draw down blade to a dry coating thickness of approximately 1 mil. The sample was allowed to flash at room temperature for 10 minutes and then oven baked for 10 minutes at 180°C. The samples were immersed in water at 85°C for 72 hours and tested for coating adhesion as in Example 1. There was excellent adhesion as noted by a 100% retention of squares on the substrate.

### Example 3 (90:10 Isophorone-cyclohexanone solvent blend)

A mixed solvent blend, as described in the Table 5 below, was used to formulate a PVDF-acrylic dispersion coating. This is to demonstrate the ability to use mixtures of latent solvents for dispersion coatings. These solvents are not considered "active" solvents, and will not appreciably swell PVDF resin at room temperature. This blend was prepared as described in Example 1, using a 90:10 ratio of isophorone to cyclohexanone as the solvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 5**

| **Solvent Dispersion Example #3** | **Amount (g)** |
|---|---|
| PVDF homopolymer resin, as described in example 1 | 20.5 |
| PARALOID B44 (40% solution in toluene) | 21.90 |
| Isophorone | 37.6 |
| Cyclohexanone | 4.2 |
| R-960-TiO2 | 15.8 |

### Example 4 (80:20 Isophorone-cyclohexanone solvent blend)

The mixed solvent blend, as described in the Table 6 below, was used to formulate a PVDF-acrylic dispersion coating. This blend was prepared as described in Example 1, using a 90:10 ratio of isophorone to cyclohexanone as thesolvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 6**

| **Solvent Dispersion Example #4** | **Amount (g)** |
|---|---|
| PVDF homopolymer resin, as described in example 1 | 20.5 |
| PARALOID B44 (40% solution in toluene) | 21.90 |
| Isophorone | 33.4 |
| Cyclohexanone | 8.4 |
| R-960 - TiO2 | 15.8 |

### Example 5 (70:30 Isophorone-cyclohexanone solvent blend)

A mixed solvent blend, as described in the Table 7 below, was used to formulate a PVDF-acrylic dispersion coating. This blend was prepared as described in Example 1, using a 90:10 ratio of isophorone to cyclohexanone as the solvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 7**

| **Solvent Dispersion Example #5** | **Amount (g)** |
|---|---|
| PVDF homopolymer resin, as described in example 1 | 20.5 |
| PARALOID B44 (40% solution in toluene) | 21.90 |
| Isophorone | 29.3 |
| Cyclohexanone | 12.5 |
| R-960 - TiO2 | 15.8 |

### Example 6 (50:50 Isophorone-cyclohexanone solvent blend)

A mixed solvent blend, as described in the Table 8 below, was used to formulate a PVDF-acrylic dispersion coating. This blend was prepared as described in Example 1, using a 90:10 ratio of isophorone to cyclohexanone as the solvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 8**

| **Solvent Dispersion Example #6** | **Amount (g)** |
|---|---|
| PVDF homopolymer resin, as described in example 1 | 20.5 |
| PARALOID B44 (40% solution in toluene) | 21.90 |
| Isophorone | 20.9 |
| Cyclohexanone | 20.9 |
| R-960 - TiO2 | 15.8 |

### Example 7 (30:70 Isophorone-cyclohexanone solvent blend)

A mixed solvent blend, as described in the Table 9 below, was used to formulate a PVDF-acrylic dispersion coating. This blend was prepared as described in Example 1, using a 90:10 ratio of isophorone to cyclohexanone as the solvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 7).

**TABLE 9**

| **Solvent Dispersion Example #7** | **Amount (g)** |
|---|---|
| PVDF homopolymer resin, as described in example 1 | 20.5 |
| PARALOID B44 (40% solution in toluene) | 21.90 |
| Isophorone | 12.5 |
| Cyclohexanone | 29.3 |
| R-960 - TiO2 | 15.8 |

### Example 8 (20:80 Isophorone-cyclohexanone solvent blend)

A mixed solvent blend, as described in the Table 10 below, was used to formulate a PVDF-acrylic dispersion coating. This blend was prepared as described in Example 1, using a 90:10 ratio of isophorone to cyclohexanone as thesolvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 10**

| **Solvent Dispersion Example #8** | **Amount (g)** |
|---|---|
| PVDF homopolymer resin, as described in example 1 | 20.5 |
| PARALOID B44 (40% solution in toluene) | 21.90 |
| Isophorone | 8.4 |
| Cyclohexanone | 33.4 |
| R-960 - TiO2 | 15.8 |

### Example 9 (10:90 Isophorone-cyclohexanone solvent blend)

A mixed solvent blend, as described in the Table 11 below, was used to formulate a PVDF-acrylic dispersion coating. This blend was prepared as described in Example 1, using a 90:10 ratio of isophorone to cyclohexanone as thesolvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 11**

| **Solvent Dispersion Example #9** | **Amount (g)** |
|---|---|
| PVDF homopolymer resin, as described in example 1 | 20.5 |
| PARALOID B44 (40% solution in toluene) | 21.90 |
| Isophorone | 4.2 |
| Cyclohexanone | 37.6 |
| R-960 - TiO2 | 15.8 |

### Example 10 Use of Alternate Acrylic Resins

To demonstrate the use of other commercial PMMA based acrylic resins in this invention, the following formulation was prepared and coated on PET film by the method of Example 1. Coating was smooth and defect free after baking, and passed 1000 hours of damp humidity exposure without failing adhesion test.

**TABLE 12**

| **Solvent Dispersion Example w/ Other acrylic resins** | **Amount (g)** |
|---|---|
| PVDF homopolymer | 20.5 |
| PMMA acrylic resin (PLEXIGLAS VH100NA, Altuglas) | 8.8 |
| Toluene | 14.0 |
| Isophorone | 41.8 |
| R-960 - TiO2 | 15.8 |

### Example 11 (Use of maleic anhydride functional PVDF (KYNAR ADX) co-resin with 90:10 isophorone / cyclohexanone solvent blend, with B44 acrylic resin)

A mixed solvent blend, as described in the Table 13below, was used to formulate a PVDF-acrylic dispersion coating. This blend was prepared as described in Example 1, using a 90:10 ratio of isophorone to cyclohexanone as thesolvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 13**

| **Solvent Dispersion Example #11** | **Amount (g)** |
|---|---|
| PVDF homopolymer resin, as described in example 1 | 16.5 |
| KYNAR ADX | 4.0 |
| PARALOID B44 (40% solution in toluene) | 21.90 |
| Isophorone | 37.6 |
| Cyclohexanone | 4.2 |
| R-960 - TiO2 | 15.8 |

### Example 12 (Use of KYNAR ADX co-resin with 50:50 isophorone / cyclohexanone solvent blend, with B44 acrylic resin)

A mixed solvent blend, as described in the Table 14 below, was used to formulate a PVDF-acrylic dispersion coating. This blend was prepared as described in Example 1, using a 90:10 ratio of isophorone to cyclohexanone as thesolvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 14**

| **Solvent Dispersion Example #12** | **Amount (g)** |
|---|---|
| PVDF homopolymer resin, as described in example 1 | 16.5 |
| KYNAR ADX111 | 4.0 |
| PARALOID B44 (40% solution in toluene) | 21.90 |
| Isophorone | 20.9 |
| Cyclohexanone | 20.9 |
| R-960 - TiO2 | 15.8 |

### Example 13 (Use of KYNAR ADX functional PVDF co-resin with 10:90 isophorone / cyclohexanone solvent blend, with B44 acrylic resin)

A mixed solvent blend, as described in the Table 15 below, was used to formulate a PVDF-acrylic dispersion coating. This blend was prepared as described in Example 1, using a 90:10 ratio of isophorone to cyclohexanone as the solvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 15**

| **Solvent Dispersion Example #13** | **Amount (g)** |
|---|---|
| PVDF homopolymer resin, as described in Example 1 | 16.5 |
| KYNAR ADX 111 | 4.0 |
| PARALOID B44 (40% solution in toluene) | 21.90 |
| Isophorone | 4.2 |
| Cyclohexanone | 37.6 |
| R-960 - TiO2 | 15.8 |

### Example 14 (Use of KYNAR ADX functional PVDF co-resin with 10:90 isophorone / cyclohexanone solvent blend, with A-21 acrylic resin)

A mixed solvent blend, as described in the Table 16 below, was used to formulate a PVDF-acrylic dispersion coating. This blend was prepared as described in Example 1, using a 10:90 ratio of isophorone to cyclohexanone as thesolvent. The formulation was coated onto primed PET film (SKC SH22), allowed to evaporate for 10 minutes at room temperature, then baked at 200°C for 10 minutes. After cooling, coatings showed 100% adhesion by cross hatch testing. Additional testing was conducted by exposing coated sheet to humidity (85%, 85C, Thermotron exposure unit). This type of humidity exposure is a more common performance test, compared to simple immersion testing. After 1000 hours of exposure, the coating retained 100% adhesion (see Table 17).

**TABLE 16**

| **Solvent Dispersion Example #14** | **Amount (g)** |
|---|---|
| PVDF homopolymer resin, as described in example 1 | 16.5 |
| KYNAR ADX 111 powder | 4.0 |
| PARALOID A21 | 8.8 g |
| Toluene | 13.2 g |
| Isophorone | 4.2 |
| Cyclohexanone | 37.6 |
| R-960 - TiO2 | 15.8 |

**TABLE 17 Cross Hatch Adhesion Data For Humidity Exposed Coatings After 1000 Hours At 85°C / 85% Relative Humidity**

| **Example #** | **Description** | **% X-Hatch squares retained** |
|---|---|---|
| 1 | PVDF/acrylic 100% isophorone | 100 |
| 3 | PVDF/acrylic 90% isophorone / 10% cyclohexanone | 100 |
| 4 | PVDF/acrylic 80% isophorone / 20% cyclohexanone | 100 |
| 5 | PVDF/acrylic 70% isophorone / 30% cyclohexanone | 100 |
| 6 | PVDF/acrylic 50% isophorone / 50% cyclohexanone | 100 |
| 7 | PVDF/acrylic 30% isophorone / 70% cyclohexanone | 100 |
| 8 | PVDF/acrylic 20% isophorone / 80% cyc lohexanone | 100 |
| 9 | PVDF/acrylic 10% isophorone / 90% cyclohexanone | 100 |
| 10 | PVDF w/ alternate acrylic resin | 100 |
| 11 | PVDF/ADX/acrylic-B44 90% isophorone / 10% cyclohexanone | 100 |
| 12 | PVDF/ADX/acrylic-B44 500% isophorone / 500% cyclohexanone | 100 |
| 13 | PVDF/ADX/acrylic-B44 100% isophorone / 90% cyclohexanone | 100 |
| 14 PVDF/ADX/acrylic-A21 10% isophorone / 90% cyclohexanone | | 100 |

### Example 15 - Use of solution of functional PVDF resin for coating

In this example, the functional PVDF resin previously described in examples 11 - 14 may be used as a solution (fully dissolved) by itself with added acrylic resin and pigment. To practice this example, one would need to prepare a solution of the functional PVDF resin in an active solvent such as NMP or DMAC at a concentration of between 10 - 30% and blend in an appropriate amount of an acrylic resin along with pigment. Table 18 below gives a proposed formulation example

**TABLE 18**

| Functional PVDF solution coating example | Amount |
|---|---|
| Functional PVDF resin | 20.0 g |
| Acrylic resin | 8.6 g |
| NMP | 44.4 |
| Pigment (TiO₂) | 15.8 g |

This formulation would be mixed using standard methods and equipment known to those in the art. The application would also be by know procedures such as draw down, roll coating, and / or doctor blade casting. Bake temperatures would be 4 - 8 minutes at 190 - 200°C.

### Example 16 - Use of solution of functional PVDF resin in conjunction with dispersion formulation

In this example, the functional PVDF resin previously described in examples 11 - 14 may be used as a solution (fully dissolved) to blend with a PVDF dispersion formulation, similar to examples 11 - 14. This approach is an alternative to blending the dry functional PVDF resin in the dispersion formulation. To practice this example, one would need to prepare a solution of the functional PVDF resin in an active solvent such as NMP or DMAC at a concentration of between 10 - 30% and blend in with a typical dispersion formulation. Table 19 below gives a proposed formulation example

**TABLE 19**

| Functional PVDF solution in dispersion formulation | Amount |
|---|---|
| Functional PVDF resin (20% solution in NMP) | 20.0 g |
| PVDF homopolymer resin, as described in example 1 | 16.5 g |
| Acrylic resin (40% solution in toluene) | 21.9 g |
| Isophorone | 25.8 g |
| Pigment (TiO₂) | 15.8 g |

This formulation would be mixed using standard methods and equipment known to those in the art. The application would also be by know procedures such as draw down, roll coating, and / or doctor blade casting. Bake temperatures would be 4 - 8 minutes at 190 - 200°C.

### Example 17 - Low temperature bake aqueous dispersion coating with crosslinking:

A PVDF-acrylic hybrid dispersion was prepared as follows: A PVDF copolymer fluoropolymer latex: (resin composition is of 75/25 wt % VF2/HFP, latex particle size by light scattering 140 nm, 41 wt% solids) was used as received. This dispersion had a first heat DSC enthalpy of melting of 17.5 Joules/gram on dry polymer, with a principal crystalline melting peak of 103°C, VAZO® -67 (Dupont), POLYSTEP B7 ammonium lauryl sulfate (STEPAN, 30 wt % aqueous solution) are used as received. Methyl methacrylate, hydroxyethyl methacrylate, methacrylic acid, and ethyl acrylate were from Aldrich and used as received.

In a separate vessel, a monomer mixture-(monomer mixture A)-- is prepared from methyl methacrylate 210 g), hydroxyethyl methacrylate (18 g), ethyl acrylate (72 g) and isooctylmercaptopropionate (0.5 g).

In another separate vessel, a monomer mixture - (monomer mixture B) - is prepared from methyl methacrylate (87 g), hydroxyethyl methacrylate (102 g), ethyl acrylate (102 g), methacrylic acid (9 g), and isooctylmercaptopropionate (0.5 g). An initiator solution is prepared from 3.8 g VAZO - 67 (DuPont) and tripropylene glycol monomethyl ether (18.7 g).

1463 g of the fluoropolymer latex is charged into a kettle equipped with a condenser, high purity argon and monomer inlets and a mechanical stirrer. 275 g water and 15 g POLYSTEP B7 are added. After the reactor and its initial contents are flushed and purged for 10 minutes, 60 g of monomer mixture A is introduced into the reactor at a rate of 600 g / hour. Then the initiator solution is added. The reactor and its contents are stirred under argon for 30 minutes, while heating to 75° C. Then the remaining portion of monomer mixture A is added at a rate of 204 g/hour. After 30 minutes, monomer mixture B is fed at a rate of 240 g / hour. When all the monomer mixture has been added, the residual monomer is consumed by maintaining the reaction temperature at 75° C for an additional 30 minutes. Then 0.7 g of a mixture of t-butyl hydroperoxide and sodium formaldehyde sulfoxylate are added to the reactor, and the reactor is then maintained at 75° C for an additional 30 minutes. The reaction mixture is then cooled to ambient temperature, vented and the dispersion produced by the reaction filtered through a cheese cloth. The final solids content of the dispersion was measured by gravimetric method and was of 49.5 weight percent. The dispersion was neutralized with aqueous ammonia to a pH of about 7.8. The minimum film formation of the dispersion was 15 C.

A 2-component white aqueous coating was formulated based upon this dispersion, using the following formulation:

**TABLE 20**

| A component: | **Quantity, grams** |
|---|---|
| | |
| Neutralized PVDF-acrylic hybrid dispersion from above | 99.0 |
| BYK 346 (Altana) | 0.1 |
| Dipropylene glycol dimethyl ether | 3.0. |
| TiO2 Pigment concentrate, from Example 2 | 58 |

**TABLE 21**

| Final formulation, mixed on day of application: | **Quantity, grams** |
|---|---|
| | |
| A component from above | 75 |
| Water | 5 |
| BAYHYDUR XP-2655 (BayerMaterialSciences) | 5 |

The A component and the final formulation were each mixed using a low speed mixing stirrer at 500 rpm for 10 minutes.

The white aqueous coating was applied to the same pre-treated PET as in Example 1, and also to untreated PET, using a 5 mil draw down blade to a dry coating thickness of approximately 1 mil. The samples were allowed to flash at room temperature for 10 minutes and then oven baked for 30 minutes at 80°C. The samples were subjected to 85 °C/85% relative humidity damp heat testing 1000 hours and tested for coating adhesion as in Example 1. For both samples, there was excellent adhesion as noted by a 100% retention of squares on the substrate

### Example 18 - Lower Temperature Bake Dispersion Formulations

In this preferred application method, a formulation of PVDF homopolymer resin (as described in example 1) with acrylic co- resin and pigment is blended in a solvent suitable for coating in the temperature range of 170 - 180°C. Thus, the formulations in the Table 22 below were prepared and coated onto primed PET film (SKC SH81) at 5 mils wet thickness. The coatings were allowed to evaporate briefly for 1 minute at ambient temperature before being baked at 170°C for 1 minute. The lower temperatures and lower flash and bake times were designed to mimic actual exposure times in typical commercial production lines. The dried coatings were subsequently exposed to damp heat (85/85) for 1000 hours without adhesion failure Examples 18-1 to 18-6.

Included in these examples are formulations made with VF2-HFP copolymer resins. The copolymer resins may have either a random distribution of the co-monomer HFP, or be heterogenous, where the co-monomer HFP is unevenly distributed in the polymer chains. In these examples, we also tested an acrylic copolymer (PARALOID B48N) resin which had butylacrylate as co-monomer.

As comparative examples, we include tests with higher boiling solvent baked at our preferred lower temperature and a very high bake temperature coatings which show embrittlement of the PET film (Examples 18-7 and 18-8).

**TABLE 22**

| Formulation | Composition (grams of ingredients) | Adhesion after damp heat exposure 1000 hrs @ 85°C / 85%RH |
|---|---|---|
| 18-1 | PVDF homopolymer resin: 21.9 | Pass |
| | PARALOID B44 40% solution: | |
| | 21.9 | |
| | R960 TiO2: 15.9 | |
| | Di-isobutyl ketone (DIBK): 41.8 | |
| 18-2 | PVDF homopolymer resin: 21.9 | Pass |
| | PARALOID B44 40% solution: | |
| | 21.9 | |
| | R960 TiO2: 15.9 | |
| | Di-isobutyl ketone (DIBK): 27.9 | |
| | t-Butylacetate: 13.9 | |
| 18-3 | PVDF homopolymer resin: 19.0 | Pass |
| | PARALOID B44 40% soln: 19.0 | |
| | R960 TiO2: 21.7 | |
| | Cyclohexanone: 47.7 | |
| 18-4 | PVDF homopolymer resin: 19.0 | Pass |
| | PARALOID B44 40% soln: 19.0 | |
| | R960 TiO2: 21.7 | |
| | Cyclohexanone: 31.8 | |
| | t-Butylacetate: 15.9 | |
| 18-5 | PVDF homopolymer resin: 19.0 | Pass |
| | PARALOID B44 40% soln: 19.0 | |
| | R960 TiO2 | |
| | Methyl-isobutyl ketone (MIBK) | |
| 18-6 | PVDF homopolymer resin: 19.0 | Pass |
| | PARALOID B44 40% soln: 19.0 | |
| | R960 TiO2: 21.7 | |
| | Methyl-isoamyl ketone (MIAK): 47.7 | |
| 18-7 | VF2-HFP copolymer powder 19.0 (Homogeneous compolymer, Mw 385K, Mn 146K, Tm 157°C) | Pass |
| | PARALOID B48N 40% soln: 19.0 | |
| | R960 TiO2: 21.7 | |
| | Di-isobutyl ketone (DIBK): 47.7 | |
| 18-8 | VF2-HFP copolymer powder 19.0 (Homogeneous compolymer, Mw 325K, Mn 101K, Tm 144°C) | Pass |
| | PARALOID B48N 40% soln: 19.0 | |
| | R960 TiO2: 21.7 | |
| | Di-isobutyl ketone (DIBK): 47.7 | |
| 18-9 | VF2-HFP copolymer powder 19.0 (Heterogeneous copolymer, Mw 316K, Mn 100K, Tm 163°C) | Pass |
| | PARALOID B48N 40% soln: 19.0 | |
| | R960 TiO2: 21.7 | |
| | Di-isobutyl ketone (DIBK): 47.7 | |
| 18-10 Comparative Higher temp bake 230°C | Coating formulation described in example 1. Coated on PET film and baked at 230°C for 5 minutes. | Fail Film was very brittle after baking. Film cracked apart during cross-cut test after 200 hours of humidity exposure. |
| 18-11 Comparative Higher boiling solvent | PVDF homopolymer powder: 19.0 | Fail Coating failed adhesion after 200 hrs damp heat. |
| | PARALOID B44 40% soln: 19.0 | |
| | R960 TiO2: 21.7P | |
| | Propylene carbonate: 47.7 | |

### Example 19 Continuous casting line coating

The coating formulation described in example 18-4 was used to apply a coating on SKC SH 81 PET film on a continuous casting line. A 12" roll of film was pulled through a 10' oven heated to 177°C. Coating was applied by a 35 trihelix gravure roller to the moving web, traveling at a rate of 10' per minute. A defect free dry coating was obtained under these conditions, of thickness 20 um. This coating was subsequently tested by damp heat exposure for 1000 hours and passed the cross hatch adhesion test.

### Example 20 (comparative) Continuous casting line operated at higher temperature

The coating described in Example 19 was repeated, but with the oven heated to 190°C. At this temperature, the PET film shrank from an initial width of 12" to 10". The film also showed wrinkling / distortion in the center section as it was taken up at the end of the oven. When operated at 350°F, the shrinkage was less than 1" and the film was smooth.

### Example 21 Use of alternate primed PET substrates

Following the formulation and coating conditions of example 18-1, coatings were applied on the following commercial PET films: Mitsubishi 4507, Toray XG232, and Kolon Astroll CI320, all of which were surface treated with an acrylic based primer. The coatings successfully passed 1000 hours of damp heat humidity (85°C / 85% RH) without loss of adhesion.

### Example 22 (comparative) Coatings on non-primed PET film

The coating formulation of 18-1 was used to coat unprimed PET film (SKC SG002). After coating and exposure to damp heat, the coated failed adhesion test at 48 hours.

### Example 23 (comparative) Coatings on PET primed with non-compatible primer

The coating formulatin of 18-1 was used to coat a PET film primed with a urethane based primer. Urethanes are less compatible with PVDF resin than PMMA based acrylic resins. After coating and exposure to damp heat, the coating failed adhesion after 24 hours.

### Example 24 (comparative) Coatings on non-primed, corona treated PET film

Unprimed PET film was treated by high voltage corona discharge. Immediately after treatment, the film was coated with a PVDF dispersion formulation 18-4 and baked under the same conditions. After 48 hours of damp heat humidity exposure, the coating failed the adhesion test.

### Lamination Testing

To demonstrate the suitability of these coatings for photovoltaic backsheets, several samples of coated PET film were laminated to glass substrates with a bonding layer of EVA (15295P EVA obtained from STR) between the glass and the PET side of the coated film. Laminations were run on a P-Energy laminator model L036A using the following cycle:
Step 1 - 10 minutes vacuum while ramping from 100°C to 145°C.
Step 2 - Ramp to 150°C under pressure
Step 3 - Hold 150°C for 10 minutes under pressure
Step 4 - Cool to approximately 80°C under pressure
Step 5 - Release pressure and remove sample

Film samples tested included 18-1, 18-3, 18-4, and samples from the coating line trial (Example 19). Smooth films resulted after lamination with minimal surface defects. Visually, these laminated coatings appeared nearly identical to a commercial backsheet sample made by direct film lamination. Coatings passed cross cut adhesion testing after lamination.

### Weathering Data

Samples of coated PET film were tested by accelerated weathering exposure with Xenon Arc (ASTM G155) and QUVB (ASTM G53). Color (delta E*) and gloss changes were monitored. High performance, weather resistant fluoropolymer coatings typically have gloss retention greater than 70% and delta E* less than 4 after 5000 hours of QUVB accelerated weathering. Results are tabulated below.

| Coated Film Example | Xenon Arc Exposure 4000 hrs | | QUVB Exposure 3000 hrs | |
|---|---|---|---|---|
| | Delta E* | % Gloss Ret. | Delta E* | % Gloss Ret. |
| 9 | 1.32 | 125 | 2.99 | 93.7 |
| 10 | 1.27 | 109 | 2.96 | 107.6 |
| 12 | 1.32 | 113 | 2.79 | 87.5 |

At 3000 hours of QUVB, representative coatings of this invention are well within those performance targets.

## Claims

1. A photovoltaic module, comprising:
a) an outer transparent glazing material;
b) encapsulated interconnected solar cells; and
c) a backsheet comprising a polymer support substrate coated on the side exposed to the environment, or both sides with a dispersion polyvinylidene fluoride (PVDF) composition having a curing temperature of 150C to 180C, and comprising a mixture of a non-functionalized PVDF and a compatible non-functionalized acrylic resin, said dispersion comprising a solvent, wherein the solvent is a hydrophobic solvent or a mixture of such solvents having a solubility in water at 25°C of less than 10% by weight, wherein said dispersion PVDF composition forms a dry film at a temperature of from 170-180°C, and wherein non-functional acrylic resin does not contain carboxylate, amine, anhydride, isocyanate, or epoxy reactive functional groups, and wherein said dispersion fluoropolymer composition does not contain crosslinking agents.

2. The photovoltaic module of claim 1, wherein said PVDF composition comprises a polyvinylidene fluoride homopolymer or copolymer.

3. The photovoltaic module of claim 2, wherein said PVDF composition is selected from a polyvinylidene fluoride homopolymer, a polyvinylidene fluoride copolymer, a blend of a PVDF polymer with a compatible polymer wherein at least 10 percent by weight of the blend is PVDF, and an acrylic modified fluoropolymer with a minimum PVDF content of 10%.

4. The photovoltaic module of claim 1, wherein said non-functionalized acrylic is a copolymer of methylmethacrylate with acrylic monomers such as ethylacrylate or butylacrylate.

5. The photovoltaic module of claim 1, wherein said PVDF and acrylic mixture is in the form of an interpenetrating polymer network.

6. The photovoltaic module of claim 1, wherein said backsheet substrate is a primed or un-primed substrate.

7. The photovoltaic module of claim 6, wherein said primed substrate has been primed by corona treated, or by coating with an adhesive compound.

8. The photovoltaic module of claim 1, wherein said back sheet is a multi-layer structure, having said PVDF composition in the outermost layer, and further comprising at least one barrier layer selected from the group consisting of ethylene vinyl acetate, polyethylene terephthalate, polypropylene terephthalate, aluminum or reactive polyethylenes.

9. The photovoltaic module of claim 1, wherein said PVDF composition further comprises from 2 to 30 weight percent of one or more mineral pigments or fillers.

10. The photovoltaic module of claim 1, wherein said PVDF is a PVDF copolymer having from 1 to 29 weight percent of hexafluoropropene.

11. The photovoltaic module of claim 1, wherein said backsheet substrate is polyethylene terephthalate or polybutylene terephthalate substrate.

12. The photovoltaic module of claim 1, wherein said backsheet substrate further comprises a functional polyolefin.

## Patentansprüche

1. Photovoltaikmodul, umfassend:
a) ein äußeres transparentes Verglasungsmaterial;
b) verkapselte, miteinander verbundene Solarzellen; und
c) eine Rückseitenfolie, die ein Polymerträgersubstrat umfasst, das auf der der Umwelt ausgesetzten Seite oder auf beiden Seiten mit einer Dispersionszusammensetzung eines Polyvinylidenfluorids (PVDF) beschichtet ist, die eine Härtungstemperatur von 150C bis 180C aufweist und die eine Mischung von einem nichtfunktionalisierten PVDF und einem kompatiblen nichtfunktionalisierten Acrylharz umfasst, wobei die Dispersion ein Lösungsmittel umfasst, wobei es sich bei dem Lösungsmittel um ein hydrophobes Lösungsmittel oder eine Mischung von solchen Lösungsmitteln, die bei 25 °C eine Wasserlöslichkeit von weniger als 10 Gew.□% aufweisen, handelt, wobei die PVDF-Dispersionszusammensetzung bei einer Temperatur von 170-180 °C einen Trockenfilm bildet und wobei das nichtfunktionelle Acrylharz keine reaktiven funktionellen Carboxylat-, Amin-, Anhydrid-, Isocyanat- oder Epoxidgruppen enthält und wobei die Fluorpolymerdispersionszusammensetzung keine Vernetzungsmittel enthält.

2. Photovoltaikmodul nach Anspruch 1, wobei die PVDF-Zusammensetzung ein Polyvinylidenfluorid-Homopolymer oder -Copolymer umfasst.

3. Photovoltaikmodul nach Anspruch 2, wobei die PVDF-Zusammensetzung aus einem Polyvinylidenfluorid-Homopolymer, einem Polyvinylidenfluorid-Copolymer, einer Abmischung von einem PVDF-Polymer mit einem kompatiblen Polymer, wobei mindestens 10 Gewichtsprozent der Abmischung PVDF sind, und einem acrylmodifizierten Fluorpolymer mit einem PVDF-Gehalt von wenigstens 10 % ausgewählt ist.

4. Photovoltaikmodul nach Anspruch 1, wobei es sich bei dem nichtfunktionalisierten Acryl um ein Copolymer von Methacrylsäuremethylester mit Acrylmonomeren wie Ethylacrylat oder Butylacrylat handelt.

5. Photovoltaikmodul nach Anspruch 1, wobei die PVDF- und Acrylmischung in Form eines interpenetrierenden Polymernetzwerks vorliegt.

6. Photovoltaikmodul nach Anspruch 1, wobei es sich bei dem Rückseitenfoliensubstrat um ein grundiertes oder ungrundiertes Substrat handelt.

7. Photovoltaikmodul nach Anspruch 6, wobei das grundierte Substrat durch Koronabehandlung oder durch Beschichtung mit einer Haftklebemasse grundiert wurde.

8. Photovoltaikmodul nach Anspruch 1, wobei es sich bei Rückseitenfolie um einen Mehrschichtaufbau handelt, der die PVDF-Zusammensetzung in der äußersten Schicht aufweist und ferner mindestens eine aus der Gruppe bestehend aus Ethylenvinylacetat, Polyethylenterephthalat, Polypropylenterephthalat, Aluminium oder reaktiven Polyethylenen ausgewählte Barriereschicht umfasst.

9. Photovoltaikmodul nach Anspruch 1, wobei die PVDF-Zusammensetzung ferner 2 bis 30 Gewichtsprozent von einem oder mehreren mineralischen Pigmenten oder Füllstoffen umfasst.

10. Photovoltaikmodul nach Anspruch 1, wobei es sich bei dem PVDF um ein PVDF-Copolymer handelt, das 1 bis 29 Gewichtsprozent Hexafluorpropen aufweist.

11. Photovoltaikmodul nach Anspruch 1, wobei es sich bei dem Rückseitenfoliensubstrat um ein Polyethylenterephthalat- oder Polybutylenterephthalatsubstrat handelt.

12. Photovoltaikmodul nach Anspruch 1, wobei das Rückseitenfoliensubstrat ferner ein funktionelles Polyolefin umfasst.

## Revendications

1. Module photovoltaïque, comprenant :
a) un matériau de vitrage transparent extérieur ;
b) des cellules solaires interconnectées encapsulées ; et
c) une feuille arrière comprenant un substrat de support de polymère revêtue sur le côté exposé à l'environnement, ou sur les deux côtés, avec une composition de poly(fluorure de vinylidène) (PVDF) en dispersion possédant une température de durcissement de 150 °C à 180 °C, et comprenant un mélange d'un PVDF non fonctionnalisé et d'une résine acrylique non fonctionnalisée compatible, ladite dispersion comprenant un solvant, le solvant étant un solvant hydrophobe ou un mélange de tels solvants possédant une solubilité dans l'eau à 25 °C inférieure à 10 % en poids, ladite composition de PVDF en dispersion formant un film sec à une température allant de 170 à 180 °C, et la résine acrylique non fonctionnelle ne contenant pas de groupes fonctionnels réactifs de type carboxylate, amine, anhydride, isocyanate, ou époxy, et ladite composition de fluoropolymère en dispersion ne contenant pas d'agents de réticulation.

2. Module photovoltaïque selon la revendication 1, ladite composition de PVDF comprenant un homopolymère ou copolymère de poly(fluorure de vinylidène).

3. Module photovoltaïque selon la revendication 2, ladite composition de PVDF étant choisie parmi un homopolymère de poly(fluorure de vinylidène), un copolymère de poly(fluorure de vinylidène), un assemblage d'un polymère PVDF avec un polymère compatible, au moins 10 pour cent en poids de l'assemblage étant du PVDF, et un fluoropolymère modifié par acrylique doté d'une teneur minimale en PVDF de 10 %.

4. Module photovoltaïque selon la revendication 1, ledit acrylique non fonctionnalisé étant un copolymère de méthacrylate de méthyle avec des monomères acryliques tels que l'acrylate d'éthyle ou l'acrylate de butyle.

5. Module photovoltaïque selon la revendication 1, ledit mélange de PVDF et d'acrylique étant sous la forme d'un réseau de polymère interpénétrant.

6. Module photovoltaïque selon la revendication 1, ledit substrat de feuille arrière étant un substrat apprêté ou non apprêté.

7. Module photovoltaïque selon la revendication 6, ledit substrat apprêté ayant été apprêté par traitement corona, ou par revêtement avec un composé adhésif.

8. Module photovoltaïque selon la revendication 1, ladite feuille arrière étant une structure multicouche possédant ladite composition de PVDF dans la couche la plus à l'extérieur, et comprenant en outre au moins une couche barrière choisie dans le groupe constitué par un éthylène-acétate de vinyle, un poly(téréphtalate d'éthylène), un poly(téréphtalate de propylène), l'aluminium et des polyéthylènes réactifs.

9. Module photovoltaïque selon la revendication 1, ladite composition de PVDF comprenant en outre de 2 à 30 pour cent en poids d'un(e) ou plusieurs pigments minéraux ou charges minérales.

10. Module photovoltaïque selon la revendication 1, ledit PVDF étant un copolymère de PVDF possédant de 1 à 29 pour cent en poids d'hexafluoropropène.

11. Module photovoltaïque selon la revendication 1, ledit substrat de feuille arrière étant un substrat de poly(téréphtalate d'éthylène) ou de poly(téréphtalate de butylène).

12. Module photovoltaïque selon la revendication 1, ledit substrat de feuille arrière comprenant en outre une polyoléfine fonctionnelle.
